# FASCICULE DE BREVET EUROPEEN

(11) **EP 2 338 318 B1**
(45) Date de publication et mention de la délivrance du brevet: **01.04.2015**
(21) Numéro de dépôt: 09760171.0
(22) Date de dépôt: 16.10.2009
(51) Int. Cl.: H05H 1/46, H01J 27/16, H01J 37/08, H01J 37/317

(54) **SOURCE DE PLASMA GAZEUX BASSE PUISSANCE**
NIEDERLEISTUNGS-GASPLASMAQUELLE
LOW-POWER GASEOUS PLASMA SOURCE

(30) Priorité: 17.10.2008 FR 0857068
(43) Date de publication de la demande: 29.06.2011
(73) Titulaire: Centre National de la Recherche Scientifique, 75794 Paris Cedex 16 (FR)
(72) Inventeur: SORTAIS, Pascal, F-38240 Meylan (FR); LAMY, Thierry, F-38000 Grenoble (FR)
(74) Mandataire: Thibon, Laurent
(86) Numéro de dépôt international: PCT/FR2009/051986
(87) Numéro de publication internationale: WO 2010/043831

(56) Documents cités:
- FR-A- 2 884 043
- JP-A- 9 245 658
- US-A- 5 180 948
- US-A- 5 565 738
- US-A- 5 936 352
- SHYAM A ET AL: "Effect of Anode and Insulator Materials on Plasma Focus Sheath (Pinch) Current" IEEE TRANSACTIONS ON PLASMA SCIENCE, IEEE SERVICE CENTER, PISCATAWAY, NJ, US, vol. 25, no. 5, 1 octobre 1997 (1997-10-01), XP011044927 ISSN: 0093-3813
- FUSELLIER C ET AL: "Electron cyclotron resonance applicator of the Wilkinson microwave power divider type for large diameter ion sources" REVIEW OF SCIENTIFIC INSTRUMENTS, AIP, MELVILLE, NY, US, vol. 69, no. 2, 1 février 1998 (1998-02-01), pages 843-845, XP012036380 ISSN: 0034-6748

## Description

### Domaine de l'invention

La présente invention concerne une source de plasma gazeux et plus particulièrement une source dans laquelle le plasma est obtenu par interaction entre un rayonnement électromagnétique haute fréquence et un gaz à basse pression.

### Exposé de l'art antérieur

Il est connu qu'en appliquant un rayonnement électromagnétique à un gaz à basse pression, ce gaz est susceptible de s'ioniser et de former un plasma dans une zone où le champ électromagnétique haute fréquence présente une intensité suffisante. Etant données les conditions d'amorçage et d'entretien d'un plasma (conditions de Paschen), il est généralement nécessaire d'utiliser une source de haute fréquence relativement puissante, et on s'oriente généralement vers l'utilisation de magnétrons. L'avantage du magnétron réside dans sa possibilité de fournir à un coût raisonnable de fortes puissances (de l'ordre de 10 à 100 watts moyens ou plus), ce qui facilite l'obtention de conditions d'amorçage. Par contre, le transport et l'adaptation de cette puissance entre le magnétron et la zone où on veut créer le plasma induisent de fortes contraintes dimensionnelles et techniques comme la dimension des guides d'ondes, les systèmes de refroidissement, les passages sous vide, etc.

Par ailleurs, on connaît des sources haute fréquence (dans le domaine des ondes centimétriques, d'une fréquence de 0,4 à 10 GHz) utilisant des oscillateurs à transistors. Ces sources, largement utilisées dans le domaine des téléphones portables et des systèmes de communication WIFI sont maintenant peu coûteuses et peu encombrantes dans le cas où leur puissance est inférieure à 10 watts (par exemple dans le domaine de 0,2 à 5 watts).

L'article Shyam et al. dans IEEE transactions on plasma science vol. 25 no. 5, 1 octobre 1997 et le brevet US 5 936 352 décrivent des générateurs de plasma.

Une fois que l'on dispose d'une source de plasma, de nombreuses applications sont possibles pour une telle source. Par exemple, on peut l'utiliser effectivement comme source de plasma pour le traitement de matériaux disposés au voisinage immédiat de la zone de création de plasma. Elle peut aussi servir de source de lumière. Elle peut aussi servir de source d'ions qui sont extraits de la zone de création de plasma.

La présente invention vise à réaliser une source de plasma qui évite au moins certains des inconvénients des dispositifs existants.

Un objet plus particulier d'un mode de réalisation de la présente invention est de prévoir une source de plasma pouvant être excitée par un oscillateur haute fréquence à transistors.

Un autre objet d'un mode de réalisation de la présente invention est de réaliser une source de plasma de petites dimensions.

Un autre objet d'un mode de réalisation de la présente invention est de réaliser une source de plasma modulable.

Un autre objet d'un mode de réalisation de la présente invention est de réaliser des sources de plasma assemblables en panneau pour constituer une source de plasma de grande surface.

Un autre objet d'un mode de réalisation de la présente invention est de réaliser une source de plasma particulièrement adaptée à la réalisation d'une source de lumière.

Un autre objet d'un mode de réalisation de la présente invention est de réaliser une source de plasma particulièrement adaptée à la réalisation d'une source d'ions.

### Résumé

Pour atteindre tout ou partie de ces objets ainsi que d'autres, un mode de réalisation de la présente invention prévoit une source de plasma comprenant une première tige formant une antenne quart d'onde entourée d'au moins une tige parallèle formant coupleur, sensiblement de même longueur que la première tige, mise à un potentiel de référence, les tiges formant coupleur étant régulièrement réparties radialement autour de la première tige, à une distance de l'ordre de la moitié au vingtième du quart de la longueur d'onde, l'antenne et les coupleurs étant orientés dans une même direction.

Selon un mode de réalisation de la présente invention, la source de plasma est associée à un générateur de haute fréquence dans la plage de 0,4 à 10 GHz, constitué d'un oscillateur à transistors HF.

Selon un mode de réalisation de la présente invention, la source de plasma ci-dessus est appliquée à la réalisation d'une source lumineuse, dans laquelle la source comprend trois coupleurs.

Selon un mode de réalisation de la présente invention, la source de plasma est entourée d'une enceinte conductrice transparente.

Selon un mode de réalisation de la présente invention, la source de plasma est entourée d'une enceinte isolante revêtue d'un grillage conducteur.

Selon un mode de réalisation de la présente invention, la source de plasma ci-dessus est appliquée à la mise en présence d'un plasma et d'un substrat, les extrémités des tiges étant placées dans un champ magnétique axial, la source étant disposée à faible distance du substrat, l'ensemble étant enfermé dans une atmosphère de gaz raréfié sélectionné en fonction des espèces atomiques que l'on souhaite créer dans le plasma.

Selon un mode de réalisation de la présente invention, la source de plasma ci-dessus est appliquée à la réalisation d'un implanteur ionique, la chambre entourant les trois tiges étant une chambre métallique, comprenant un plan parallèle à l'extrémité des tiges percé d'une ouverture et disposé en regard d'électrodes accélératrices.

Selon un mode de réalisation de la présente invention, il est prévu une source de plasma de grande étendue comprenant un assemblage de sources de plasma élémentaires telles que ci-dessus disposées côte à côte, chaque source élémentaire étant associée à un oscillateur haute fréquence à transistors.

Selon un mode de réalisation de la présente invention, dans la source de plasma de grande étendue, de mêmes aimants impartissent un champ axial à des sources de plasma élémentaires adjacentes.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
les figures 1A, 1B et 1C représentent respectivement une vue en perspective, une vue de face et une vue en coupe selon la ligne CC de la figure 1B d'une source de plasma selon un mode de réalisation de la présente invention utilisée en source de lumière ;
les figures 2A à 2F représentent des équipotentielles pour diverses configurations de sources de plasma, dans le cas où le gaz dans lequel se produit le plasma est enfermé dans une enceinte en un matériau isolant ;
les figures 3A à 3F représentent des équipotentielles pour diverses configurations de sources de plasma, dans le cas où le gaz dans lequel se produit le plasma est enfermé dans une enceinte en un matériau conducteur ;
la figure 4 est une vue de face schématique d'une source de plasma selon un mode de réalisation de la présente invention utilisée en générateur de plasma ;
la figure 5 est une vue de face schématique d'une source de plasma selon un mode de réalisation de la présente invention utilisée en source d'ions ; et
les figures 6A et 6B sont des vues schématiques en coupe et de dessus d'un assemblage de sources de plasma selon un mode de réalisation de la présente invention.

### Description détaillée

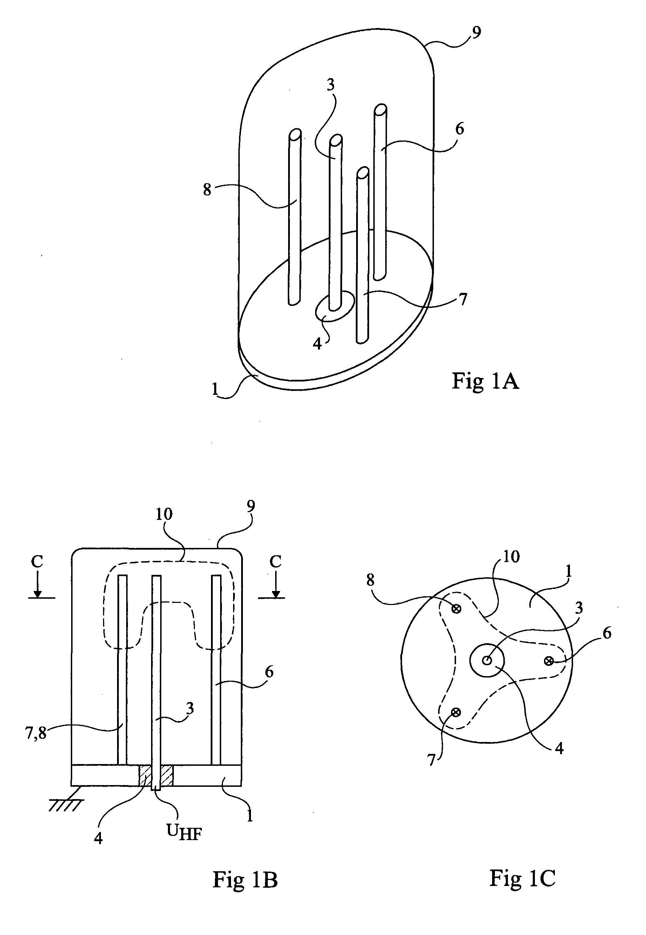

Les figures 1A, 1B et 1C représentent une source de plasma comprenant, dans une enceinte sous vide, sur un support 1, une tige centrale 3 constituant une antenne sensiblement quart d'onde à la fréquence considérée, par exemple une fréquence de l'ordre de 2,4 ou 5,8 GHz. Ainsi, si la fréquence est de l'ordre de 2,4 GHz, le quart de la longueur d'onde, λ/4, à une valeur de l'ordre de 3 cm ce qui correspond à la longueur de la tige 3. Cette tige est isolée du support par une zone 4 et est excitée par une tension haute fréquence U_{HF}. La tige 3 est entourée de trois tiges équidistantes et régulièrement réparties 6, 7, 8 ayant sensiblement la même longueur que la tige centrale et faisant fonction de coupleurs. Ces trois tiges sont reliées à un potentiel continu de référence, par exemple un plan de masse constitué par le support 1. On notera que, dans la représentation de la figure 1B, la tige 8, placée derrière la tige 7 n'est pas visible. A titre d'exemple, on a illustré cette source de plasma disposée dans une enceinte 9, transparente, par exemple en quartz, pour constituer une source de lumière.

La distance radiale entre chacune des tiges 6, 7, 8 formant coupleurs et la tige centrale formant antenne 3 est petite devant le quart de la longueur d'onde, par exemple de l'ordre de 5 à 15 fois plus petite que le quart de la longueur d'onde, de préférence de l'ordre de dix fois plus petite que le quart de la longueur d'onde. Ainsi, dans l'exemple dans lequel le quart de la longueur d'onde est de 3 cm, la distance radiale entre chacune des tiges de coupleurs et la tige formant antenne sera par exemple choisie de l'ordre de 3 mm.

Avec cette structure, on constate que, quand la tige formant antenne est excitée, il se forme un plasma dans une zone sensiblement délimitée par le contour en pointillés 10 (voir figures 1B et 1C). La zone de plasma se trouve vers les extrémités des tiges opposées au support 1 et s'étend principalement de la tige centrale 3 vers les trois coupleurs 6, 7, 8. Ceci indique qu'il existe une concentration du champ électromagnétique haute fréquence dans cette zone 10. Du fait de cette localisation du champ, une puissance relativement faible peut être utilisée pour l'amorçage et l'entretien du plasma. Alors que, typiquement, pour atteindre les conditions de création de plasma (les conditions de Paschen), il faut appliquer à une antenne quart d'onde rayonnant normalement, une puissance HF de l'ordre de 5 à 15 watts, on s'aperçoit que, ici, il suffit d'une puissance relativement faible, comprise entre 0,5 et 2 watts, pour amorcer le plasma, celui-ci se maintenant pour une puissance inférieure au watt. On considère qu'un champ de 20 kV/m sur 2,5 mm constitue un seuil d'amorçage typique pour de l'hydrogène en l'absence de champ magnétique.

Cette structure présente donc un avantage important à savoir que l'antenne peut être excitée par une source de relativement faible puissance telle qu'un oscillateur à transistors haute fréquence, du type couramment utilisé dans les téléphones portables. Il en résulte que l'ensemble de la source de plasma et de son système d'excitation peut être de petit volume et de faible encombrement. Malgré cela, dans la zone de plasma, le plasma est très intense et l'on obtient une source de lumière à forte luminosité.

Dans le fonctionnement en source de lumière, on peut utiliser des gaz tels que des mélanges argon/mercure ou xénon/mercure ou du deutérium. Un avantage de ce mode de réalisation de l'invention est que l'ensemble de la source d'excitation HF et de la lampe peut fonctionner sans refroidissement comme une lampe à basse consommation.

Plus généralement, la présente invention vise un système de génération de plasma comprenant une antenne quart d'onde associée à un ou plusieurs coupleurs disposés à faible distance de ladite antenne.

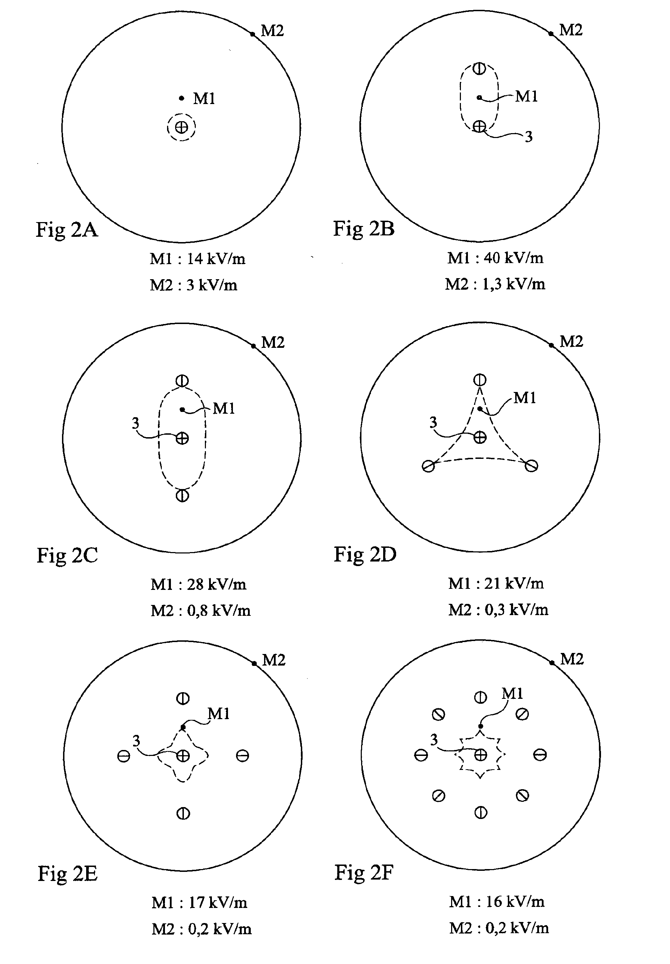

Les figures 2A à 2F représentent des équipotentielles pour diverses configurations de sources de plasma, dans le cas où le gaz dans lequel se produit le plasma est enfermé dans une enceinte en un matériau isolant. On dit alors que le système est ouvert. Un tel système est non résonant. On considère des configurations associant à une antenne sensiblement quart d'onde 3 respectivement 0, 1, 2, 3, 4 et 8 coupleurs en forme de tiges quart d'onde. On se place dans le cas où les coupleurs, quand il y en a, sont à une distance radiale de l'ordre dixième du quart de la longueur d'onde (λ/40) de l'antenne. On considère le champ, d'une part, en un point M1 situé à une distance λ/80 de l'antenne dans la direction d'un coupleur quand il y en a un, d'autre part, en un point M2 disposé sur l'enveloppe servant à enfermer le gaz dans laquelle est susceptible de se créer un plasma. Dans cet exemple, le point M2 est à une distance radiale d'environ λ/10 de l'antenne.

Les figures 2A à 2F correspondent à des coupes dans un plan situé à 2 mm de l'extrémité des antennes et coupleurs dont chacun a un diamètre de 2,5 mm et une hauteur de 27 mm. On considère dans chaque cas que l'antenne est excitée à une puissance de 5 watts à une fréquence de 2,45 GHz.

Dans chacune des figures 2A à 2F, on a représenté par un trait en pointillés la ligne de champ à 20 kV/m ; ce qui signifie que, à l'intérieur du contour en pointillés, le champ est supérieur à cette valeur. Le tableau I ci-après indique les valeurs (en kV/m) des champs aux points M1 et M2 dans chacun des cas.

**Tableau I**

| Champs en M1 et M2 en kV/m - enceinte isolante | | | | | | |
|---|---|---|---|---|---|---|
| | Nombre de coupleurs | | | | | |
| | 0 | 1 | 2 | 3 | 4 | 8 |
| M1 | 14 | 40 | 28 | 21 | 17 | 16 |
| M2 | 3 | 1,3 | 0,8 | 0,3 | 0,2 | 0,2 |

Pour avoir une source de lumière efficace, il faut, d'une part, que le champ maximum soit suffisamment élevé pour permettre de déclencher un plasma (supérieur à 20 kV/m sur environ 2,5 mm), d'autre part, que le champ rayonné en dehors de l'enceinte, au-delà de M2 soit aussi faible que possible pour respecter les normes de rayonnement électromagnétique.

On constate donc que le système à une antenne et trois coupleurs est l'un des meilleurs compromis possibles étant donné qu'il existe une zone de champ intense, supérieur à 20 kV/m située sensiblement dans un triangle délimité par les trois coupleurs, d'autre part que le champ à l'extérieur de l'enceinte est très faible, inférieur à 0,3 kV/m. D'autre part, pour constituer une lampe, il convient que les coupleurs fassent le moins possible écran au rayonnement lumineux, et c'est le cas quand seulement trois coupleurs sont utilisés.

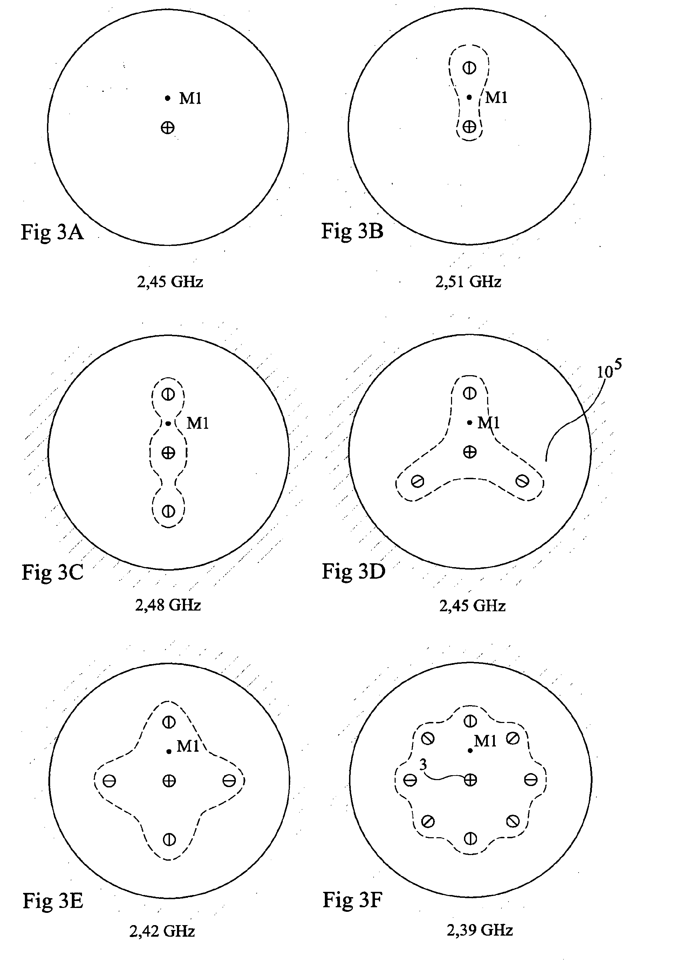

Les figures 3A à 3F représentent des structures dans lesquelles une antenne est associée respectivement à 0, 1, 2, 3, 4 et 8 coupleurs. Cette fois ci une région conductrice est disposée sur l'enceinte, ou constitue l'enceinte, ou est à l'intérieur de l'enceinte. Cette région conductrice est de préférence mise à la masse, comme les coupleurs. Dans ce cas, le champ à l'extérieur de l'enceinte est nul. Un tel système est dit fermé et est résonant.

Les figures correspondent à un cas où la puissance appliquée est de seulement 1 watt et la fréquence est voisine de 2,45 GHz. On note que si le système est résonant pour cette fréquence de 2,45 GHz dans le cas de trois coupleurs, il est respectivement résonant pour des fréquences de 2,51, 2,48, 2,42 et 2,39 GHz pour des systèmes à 1, 2, 4 et 8 coupleurs.

A nouveau, dans chacune des figures 3A à 3F, on a représenté par un trait en pointillés la ligne de champ à 20 kV/m. Le champ est encore plus concentré que dans le cas d'un système ouvert et le seuil d'amorçage est atteint pour des puissances de 1 W, voire de 0,2 W.

Il résulte de ce qui précède que, pour réaliser une source lumineuse, on préférera un système à une antenne centrale et trois coupleurs périphériques ayant tous une longueur sensiblement quart d'onde par rapport à la tension haute fréquence appliquée (U_{HF}). De préférence on placera cette structure dans une enceinte conductrice. Ainsi, pour réaliser une source de lumière, on préfèrera utiliser une enceinte conductrice transparente, par exemple une enceinte de quartz revêtue d'une couche conductrice transparente telle que de l'ITO mise au potentiel de la masse. On pourra également prévoir que le conducteur périphérique mis à la masse est un grillage ou un treillis qui ne gène pas la propagation de lumière.

Cette conclusion doit toutefois être nuancée dans le cas où l'enceinte entourant la source de plasma est conductrice. En effet, dans ce cas, quel que soit le nombre de coupleurs (≥ 1), si on adapte la fréquence autour de la valeur pour laquelle l'antenne et les coupleurs ont une longueur sensiblement quart d'onde, on trouvera toujours une fréquence de résonance très proche (à moins de 10 % près) de la fréquence pour laquelle les antennes sont normalement calculées. Ceci peut être déterminé simplement expérimentalement par l'homme de métier, sans tâtonnement, simplement en faisant varier la fréquence autour de la fréquence initialement choisie. On peut alors obtenir, quel que soit le nombre de coupleurs, sensiblement les mêmes champs que ceux que l'on obtient pour un système à trois coupleurs. On retiendra ceci quand on précisera ci-après des applications comme source de lumière, comme source de plasma directe ou comme source d'ions de la présente invention. En effet, selon l'application, il peut être intéressant d'avoir des formes particulières de plasma, par exemple un plasma étendu comme on l'obtient si on prévoit un grand nombre de coupleurs, ou un anneau coupleur continu disposé autour de l'antenne centrale.

On donnera ci-après des exemples d'application de la présente invention dans le cas où seulement trois coupleurs sont utilisés, pour simplifier les explications et la représentation mais on retiendra que l'on pourra utiliser un nombre de coupleurs quelconque notamment dans le cas où le système est un système fermé (c'est-à-dire entouré d'un milieu conducteur).

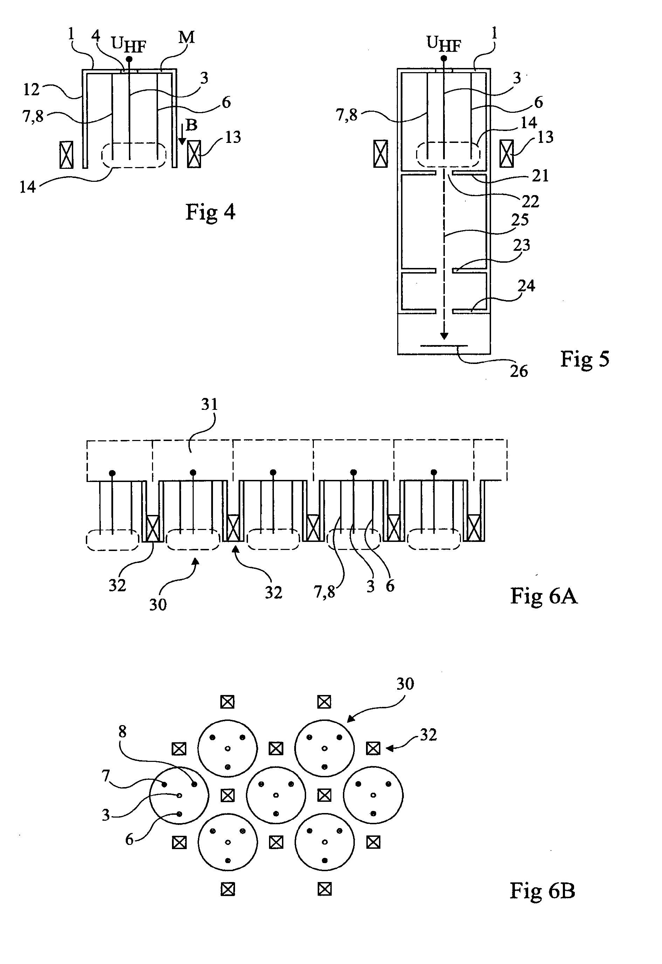

Comme l'illustre la figure 4, la source de plasma, représentée très schématiquement, peut comprendre autour de l'antenne 3 et des trois coupleurs 6, 7 et 8, une enceinte métallique 12 et être ouverte du côté des extrémités des tiges opposées au support 1. Alors, surtout si on crée par un système d'aimants 13 un champ magnétique B parallèle à la direction des tiges, il se crée une zone de plasma 14 qui s'étend au-delà de l'extrémité des tiges. Ceci peut être utilisé de façon classique pour agir sur un substrat (non représenté) situé en face de l'extrémité libre des tiges.

La figure 5 illustre très schématiquement une application de la source de plasma de la figure 5 à la réalisation d'une source d'ions. La partie haute de la figure 5 est identique à la figure 4. Toutefois cette fois-ci, la cavité est fermée du côté de l'extrémité des antennes et coupleurs 3, 6, 7, 8 par une plaque conductrice 21 munie d'une ouverture 22. Des électrodes accélératrices 23 et 24 sont prévues pour extraire des ions selon un faisceau 25 dirigé vers une cible 26. Bien entendu, l'ensemble est fermé et empli de gaz à faible pression ou d'espèces gazeuses à partir desquelles on veut former le faisceau d'ions. En outre, de façon classique, on insèrera dans le trajet du faisceau d'ions un monochromateur, par exemple un filtre de Wien, destiné à isoler l'espèce avec laquelle on souhaite bombarder la cible.

On notera qu'à condition de choisir de façon appropriée les polarisations des diverses plaques, on pourra également extraire du plasma un faisceau d'électrons.

Selon un aspect d'un mode de réalisation de la présente invention, on tire avantage du caractère compact et de la faible puissance d'excitation nécessaire pour réaliser une source de plasma de grande étendue, comme le représentent les figures 6A et 6B.

Les figures 6A et 6B représentent, respectivement en vue de face et en vue de dessous, un assemblage côte à côte d'un grand nombre de cellules plasma 30 dont chacune est par exemple constituée de la façon illustrée en figure 4. Chacune de ces cellules plasma est associée à un oscillateur de génération RF à transistors représenté sous forme de bloc et désigné par la référence 31. Etant données les dimensions en cause, on a largement la place d'associer à chaque cellule plasma un oscillateur RF à transistors fournissant une puissance de pointe de 1 à 3 watts (pour l'amorçage du plasma) et une puissance en régime permanent de l'ordre de 0,2 à 0,5 watts. Un avantage d'une telle structure en panneau de cellules est que des aimants 32 de création du champ d'expansion du plasma peuvent être placés de façon à servir d'aimants pour deux cellules adjacentes.

A titre d'exemple, chacune des cellules sera une cellule cylindrique d'un diamètre de l'ordre de 1,5 à 2,5 cm, les cellules étant disposées à un pas de l'ordre de 2 à 4 cm.

Bien entendu, la source de plasma étendue réalisée peut être utilisée directement comme source de plasma ou peut être associée à des systèmes d'accélération du type de ceux illustrés en figure 5 pour constituer une source d'ions de grande étendue, par exemple utilisable pour une implantation ionique lors de la fabrication de composants semiconducteurs.

Un avantage d'associer à chaque cellule source de plasma un oscillateur d'excitation spécifique est que l'on peut réaliser un réglage précis de l'intensité de chaque source de plasma, pour les rendre toutes égales, ou au contraire pour obtenir un profil sélectionné de répartition de densité de plasma.

Bien que l'on ait représenté en figures 6A et 6B seulement un petit nombre de cellules, pour la simplicité du dessin, on notera que la structure selon la présente invention se prête à la mise en pavé d'un grand nombre de cellules, par exemple de l'ordre de 100 ou plus.

Bien que la présente invention ait été présentée de façon générale, on notera qu'elle est susceptible de nombreuses variantes. Notamment, bien que l'on ait utilisé le mot "tige" pour désigner l'antenne et chacun des coupleurs, on comprendra que ces éléments peuvent être des éléments conducteurs ou revêtus de conducteur et pourront par exemple être des fils si leur résistance mécanique est suffisante. Ces coupleurs pourront également être des éléments cylindriques à section non circulaire pour conférer une forme particulière à la zone de plasma ou pour avoir une fonction de réflecteur optique.

Les différents gaz généralement utilisés dans les sources de plasma pour la fourniture de sources lumineuses, telles que du xénon, de l'argon, de l'azote... pourront être utilisés ici. Dans le cas de sources de plasma utilisées en tant que telles ou de sources d'ions, on incorporera dans le gaz des éléments propres à fournir les espèces actives recherchées tels que PH₃, B₂H₆, SF₆, CH₄...

Des modes de réalisation particuliers de la présente invention ont été décrits. Diverses variantes et modifications apparaîtront à l'homme de l'art. En particulier, les dimensions données l'ont été uniquement à titre d'exemple.

## Revendications

1. Source de plasma excitée par un signal haute fréquence comprenant une première tige (3) formant une antenne quart d'onde entourée d'au moins une tige parallèle formant coupleur (6, 7, 8), sensiblement de même longueur que la 5 première tige, mise à un potentiel de référence, **caractérisé en ce que** les tiges formant coupleur sont régulièrement réparties radialement autour de la première tige, à une distance de l'ordre de la moitié au vingtième du quart de la longueur d'onde, l'antenne et les coupleurs étant orientés dans une même direction.

2. Source de plasma selon la revendication 1, comprenant un générateur de haute fréquence dans la plage de 0,4 à 10 GHz, constitué d'un oscillateur à transistors HF.

3. Application de la source de plasma selon la revendication 1 à la réalisation d'une source lumineuse, dans laquelle la source comprend trois coupleurs.

4. Application de la source de plasma selon la revendication 3, dans laquelle, la source de plasma est entourée d'une enceinte conductrice transparente.

5. Application de la source de plasma selon la revendication 3, dans laquelle, la source de plasma est entourée d'une enceinte isolante revêtue d'un grillage conducteur.

6. Application de la source de plasma selon la revendication 1 à la mise en présence d'un plasma et d'un substrat, dans laquelle les extrémités des tiges sont placées dans un champ magnétique axial, la source étant disposée à faible distance du substrat, l'ensemble étant enfermé dans une atmosphère de gaz raréfié sélectionné en fonction des espèces atomiques que l'on souhaite créer dans le plasma.

7. Application de la source de plasma selon la revendication 6 à la réalisation d'un implanteur ionique, comprenant trois tiges formant coupleur, dans laquelle la chambre entourant les trois tiges est une chambre métallique, comprenant un plan parallèle à l'extrémité des tiges percé d'une ouverture et disposé en regard d'électrodes accélératrices.

8. Source de plasma comprenant un assemblage de sources de plasma élémentaires selon la revendication 1 disposées côte à côte, chaque source élémentaire étant associée à un oscillateur haute fréquence à transistors.

9. Source de plasma selon la revendication 8, dans laquelle de mêmes aimants impartissent un champ axial à des sources de plasma élémentaires adjacentes.

## Patentansprüche

1. Plasmaquelle, die von einem Hochfrequenz-Signal erregt wird, die einen ersten Stab (3) aufweist, der eine Viertelwellenantenne bildet, die mit zumindest einen parallelen Stab umgeben ist, der einen Koppler (6, 7, 8) bildet, im Wesentlichen die gleiche Länge wie der erste Stab hat und auf eine Referenzspannung gebracht ist, **dadurch gekennzeichnet, dass** die den Koppler bildenden Stäbe gleichmäßig radial um den ersten Stab verteilt sind, und zwar auf einer Distanz, die von ungefähr einer Hälfte bis zu einem Zwanzigstel des Viertels der Wellenlänge variiert, wobei die Antenne und die Koppler in die gleiche Richtung orientiert sind.

2. Plasmaquelle nach Anspruch 1, die einen Hochfrequenz-Generator im Bereich von 0,4 bis 10 GHz aufweist, der aus einem HF-Transistor-Oszillator gebildet wird.

3. Anwendung der Plasmaquelle nach Anspruch 1 zum Bilden einer Lichtquelle, wobei die Lichtquelle drei Koppler aufweist.

4. Anwendung der Plasmaquelle nach Anspruch 3, wobei die Plasmaquelle mit einer transparenten leitenden Umhüllung umgeben ist.

5. Anwendung der Plasmaquelle nach Anspruch 3, wobei die Plasmaquelle mit einer isolierenden Umhüllung umgeben ist, die mit einem leitenden Gitter beschichtet ist.

6. Anwendung der Plasmaquelle nach Anspruch 1 auf das Anordnen eines Substrates in der Anwesenheit eines Plasmas, wobei die Enden der Stäbe in einem axialen Magnetfeld angeordnet sind, wobei die Quelle in einer kleinen Entfernung vom Substrat angeordnet ist, wobei die Anordnung in einer Vakuumgasatmosphäre eingeschlossen ist, die gemäß der Arten der Atome ausgewählt ist, die in dem Plasma erzeugt werden sollen.

7. Anwendung der Plasmaquelle nach Anspruch 6, auf das Bilden eines Ionen-Implantierers, der drei einen Koppler bildende Stäbe aufweist, wobei die Kammer, welche die drei Stäbe umgibt, eine Metallkammer ist, die eine Ebene parallel zum Ende der Stäbe aufweist, durch die eine Öffnung verläuft, und die gegenüberliegend von Beschleunigungselektroden angeordnet ist.

8. Plasmaquelle, die eine Anordnung von elementaren Plasmaquellen nach Anspruch 1 aufweist, die Seite an Seite angeordnet sind, wobei jede elementare Quelle mit einem Hochfrequenz-Transistor-Oszillator assoziiert ist.

9. Plasmaquelle nach Anspruch 8, wobei die gleichen Magneten ein axiales Feld auf die elementaren benachbarten Plasmaquellen aufbringen.

## Claims

1. A plasma source excited by a high-frequency signal comprising a first rod (3) forming a quarter-wave antenna surrounded with at least one parallel rod forming a coupler (6, 7, 8), substantially of same length as the first rod, set to a reference voltage, **characterized in that** the coupler-forming rods are regularly distributed, radially, around the first rod, at a distance varying from approximately half to one twentieth of the quarter of the wavelength, the antenna and the couplers being oriented in a same direction.

2. The plasma source of claim 1, comprising a high-frequency generator in the range from 0.4 to 10 GHz, formed of an HF transistor oscillator.

3. An application of the plasma source of claim 1 to the forming of a light source, wherein the source comprises three couplers.

4. An application of the plasma source of claim 3, wherein the plasma source is surrounded with a transparent conductive enclosure.

5. An application of the plasma source of claim 3, wherein the plasma source is surrounded with an insulating enclosure coated with a conductive mesh.

6. An application of the plasma source of claim 1 to the placing of a substrate in the presence of a plasma, wherein the ends of the rods are placed in an axial magnetic field, the source being arranged at a small distance from the substrate, the assembly being enclosed in a vacuum gas atmosphere selected according to the atomic species which are desired to be created in the plasma.

7. An application of the plasma source of claim 6 to the forming of an ion implanter, comprising three coupler forming rods, wherein the chamber surrounding the three rods is a metal chamber, comprising a plane parallel to the end of the rods pierced with an opening and arranged opposite to accelerating electrodes.

8. A plasma source comprising an assembly of elementary plasma sources according to claim 1 arranged side by side, each elementary source being associated with a high-frequency transistor oscillator.

9. The plasma source of claim 8, wherein same magnets apply an axial field to elementary adjacent plasma sources.
